# EUROPEAN PATENT SPECIFICATION

(11) **EP 0 849 805 B1**
(45) Date of publication and mention of the grant of the patent: **21.05.2003**
(21) Application number: 98104516.4
(22) Date of filing: 21.11.1995
(51) Int. Cl.: H01L 29/10, H01L 29/06

(54) **MOS type semiconductor device**
Halbleiteranordnung MOS-typ
Dispositif semi-conducteur de type MOS

(30) Priority: 21.11.1994 JP 28625494
(43) Date of publication of application: 24.06.1998
(62) Divisional of application: 95118298.9
(73) Proprietor: FUJI ELECTRIC CO. LTD., Kawasaki 210 (JP)
(72) Inventor: Fujihira, Tatsuhiko, c/o Fuji Electric Co., Ltd., Kawasaki 210 (JP)
(74) Representative: Hoffmann, Eckart, Dipl.-Ing.

(56) References cited:
- DE-A- 3 823 270
- GB-A- 2 127 222
- US-A- 4 801 986
- US-A- 5 208 471
- US-A- 5 286 984

## Description

The present invention relates to MOS type semiconductor devices such as MOS field effect transistors (MOSFETs), insulated gate bipolar transistors (IGBTs), etc., which are comprised of a plurality of cells distributed in a surface layer of a semiconductor substrate and having a gate with a metal-oxide-semiconductor (MOS) structure.

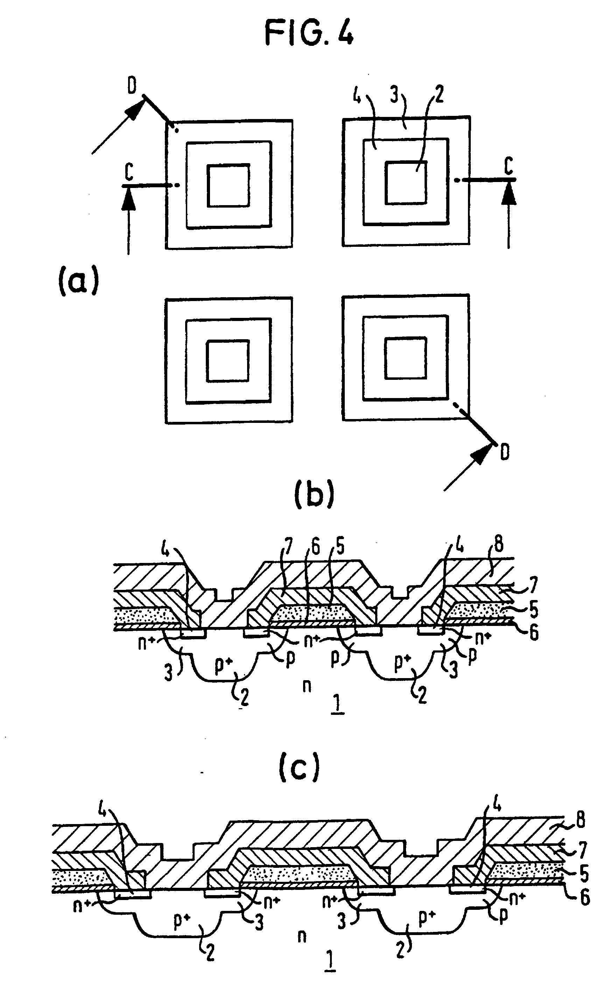

The MOS type semiconductor devices have been used very often in switching circuits because of their low ON-resistance (forward conducting resistance) and fast switching speed. Figs. 4(a) to 4(c) show an example of conventional MOS type semiconductor devices, in which Fig. 4(a) is a top plan view, Fig. 4(b) a sectional view along C-C of Fig. 4(a), and Fig. 4(c) a sectional view along D-D of Fig. 4(a). A plurality of p⁺ type well regions 2 are formed in a surface layer of an n type semiconductor layer 1. A plurality of p type channel regions 3 are formed around the well regions 2. A ring shaped source region 4 of n⁺ type is formed in a surface layer of each channel region 3. A gate electrode 5, made for example of poly-crystalline silicon, is disposed on a gate oxide film 6 on the surface of adjacent channel regions 3 and the surface of the semiconductor layer 1 exposed between these channel regions, and extends between the source regions 4 of these adjacent channel regions. A source electrode 8 of Al-Si alloy, which contacts commonly with the well regions 2 and the source regions 4 and is insulated from the gate electrodes 5 by an inter-layer insulation film 7 of BPSG (boron phosphorus silicate glass), is extended over the gate electrodes 5. Not illustrated in the figure, a drain electrode comprised of Al-Si alloy is disposed on the back surface of the semiconductor layer 1. Hereinafter, a unit structure comprised of well region 2, channel region 3, source region 4, the part of gate structure 5/6 above the channel region and source electrode 8 as shown in Figs. 4 is referred to as "cell" (as will be explained later, in some embodiments of the invention a cell has no well region but a base region instead). Though the cells shown in Fig. 4(a) are called "quadrangular cell" here, the corners of a cell rarely have an angle of 90° or less. In actual semiconductor devices, the corner of a cell is more or less rounded. For example, an actual cell may be formed in an octagon by cutting off the corners of a quadrangular cell. Hereinafter, "quadrangular cell" is meant in a broad sense covering, for instance, a polygonal cell, which includes two pairs of parallel major sides and extensions of sides not parallel to the major sides cross at around a right angle. In an actual MOSFET, many quadrangular cells are arranged side by side. The n type semiconductor layer may be a semiconductor substrate or a semiconductor layer laminated by epitaxial growth etc. on a p or n type semiconductor substrate.

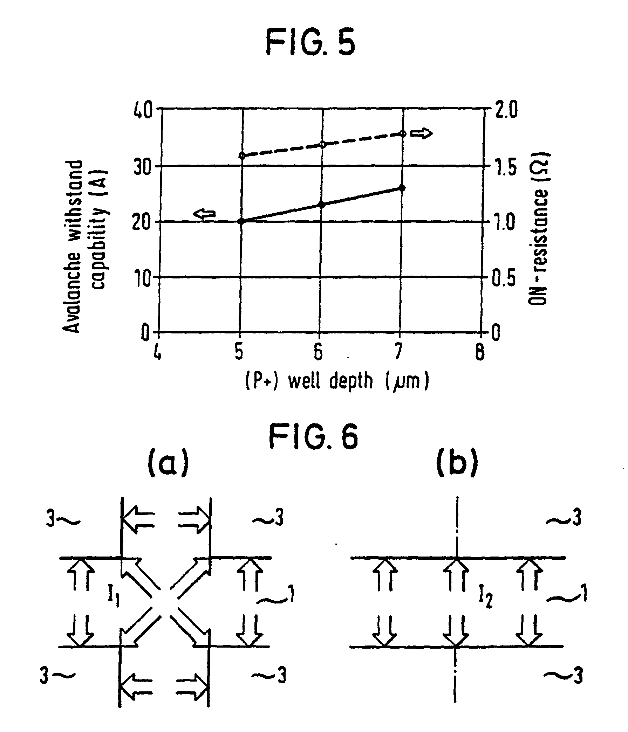

Recently, snubber circuits have been eliminated from switching circuits for circuit simplification and the down-sizing of the switching circuits has been advanced. As a result, MOSFETs used as the switching devices in such switching circuits tend to be affected by surge voltage. Since a surge voltage can cause a breakdown of the MOSFET, an improvement in the ability to withstand surge voltages and avoid breakdown (avalanche withstand capability) of the MOSFETs is needed. In the above described conventional MOSFET, the well region 2 is formed deeply to improve the avalanche withstand capability. However, the deep well region adversely affects other properties of the MOSFETs such as ON-resistance. Fig. 5 shows the typical avalanche withstand capability (solid line) and ON-resistance (broken line) versus well depth in a MOSFET element with ratings of 900 V and 5 A. In Fig. 5, the abscissa represents diffusion depth of the well region 2 and the ordinate represents avalanche withstand capability and ON-resistance. As shown in Fig. 5, the avalanche withstand capability is improved with increasing depth of the well region 2. However, the ON-resistance also increases with increasing depth of the well region 2. Therefore, considerable experimentation is required to determine the manufacturing process parameters for obtaining a depth of the well region 2 at which the avalanche withstand capability is appropriately balanced with the ON-resistance. Furthermore, to the extent that the avalanche withstand capability is balanced with the ON-resistance, improvement of the avalanche withstand capability is confined to a limited range.

The document EP-A-0 665 595 (prior art according to Art. 54(3) EPC) discloses a MOS type semiconductor device, comprising a semiconductor layer of a first conductivity type and a plurality of substantially quadrangular cells, each having four major sides and including a channel region of a second conductivity type formed in a surface layer of the semiconductor layer, and a source region of the first conductivity type formed in the surface layer of the channel region, the sides of the source region lying in parallel to the sides of the channel region, wherein the distance between opposing corners of the channel regions of two quadrangular cells is shorter than the distance between opposing sides of the channel regions of two quadrangular cells or the corners are joined.

A MOS type semiconductor device according to the precharacterizing portion of claim 1 is known from US-A-5,208,471. This document discloses, as prior art, a MOS type semiconductor device, comprising an n-type semiconductor layer, and a plurality of MOS type rectangular cells, each having four major sides including short and long major sides. Each cell includes a p⁺-type well region formed in a surface layer of the n type semiconductor layer, a p-type channel region formed around the well regions, and one or more n-type source regions formed in the surface layer of the channel region. At least two sides of said one or more source regions are in parallel to at least two sides of the channel region. The plurality of rectangular cells are formed in a central portion of a semiconductor chip and a MOS type peripheral cell is formed in a peripheral portion of the semiconductor chip, the peripheral cell including a p⁺-type well region formed in a surface layer of the n type semiconductor layer, p-type channel regions formed contiguous to the well region, and one n-type source region formed in the surface layer of each channel region. A portion of the outermost side of the channel regions of the peripheral cell lies in parallel to a respective side of the semiconductor chip. The area of the p-type channel regions in the peripheral cells is smaller than that in the remaining cells. The document teaches that the p⁺-type well region should be provided in the peripheral cell only.

US-A-4,801,986 discloses a power field effect device comprising a semiconductor layer of a first conductivity type, and a plurality of MOS type rectangular cells, each having four major sides including short and long major sides. Each cell includes a channel region of a second conductivity type formed in a surface layer of the semiconductor layer, and a source region of the first conductivity type formed in the surface layer of the channel region. At least two sides of the source region are in parallel to at least two sides of the channel region. The cells are arranged in a rectangular grid like pattern. In one embodiment, the channel regions of first and second neighboring cells which are adjacent to each other in a row direction of the grid are joined along their facing short major sides. In this embodiment, each pair of cells of two adjacent columns of the grid are arranged in the same row. In another embodiment, adjacent columns are shifted with respect to each other by half the cell pitch. In this embodiment, the short major side of the channel region of one cell is joined with the short major side of the respective channel region of two cells in the adjacent column.

The object of the present invention is to provide a MOS type semiconductor device having an improved avalanche withstand capability without other desirable properties being sacrificed.

This object is achieved by a MOS type semiconductor device according to claim 1. Preferred embodiments are subject-matter of the dependent claims.

The quadrangular cells are formed inside of peripheral cells in the outer peripheral portion of a semiconductor chip. By aligning at least a portion of the outermost side of the channel region of the peripheral cells in parallel to the respective side of the semiconductor chip, a straight pn junction can be formed. This prevents the localization of the electric field responsible for the avalanche currents. By forming the source region of the peripheral cells only on the central sides, the respective bipolar parasitic transistor is prevented from conducting even when the avalanche current flows because a source region of the first conductivity type is not formed on the outer side of the peripheral cells. By expanding the area of the peripheral cell so that it is greater than the area of the quadrangular cell, the avalanche energy absorption capability and, therefore, the avalanche withstand capability, are improved.

By forming corner cells in the corners of the semiconductor chip such that the outermost side of a channel region of these corner cells is in the form of an arc convex toward the corner of the semiconductor chip, or a plurality of straight lines connected to approximate such an arc, the curvature of the pn junction is reduced and the localization of the electric field is suppressed. By expanding the area of the corner cell to be greater than the area of the quadrangular cell, the avalanche energy absorption capability and, therefore, the avalanche withstand capability are improved.

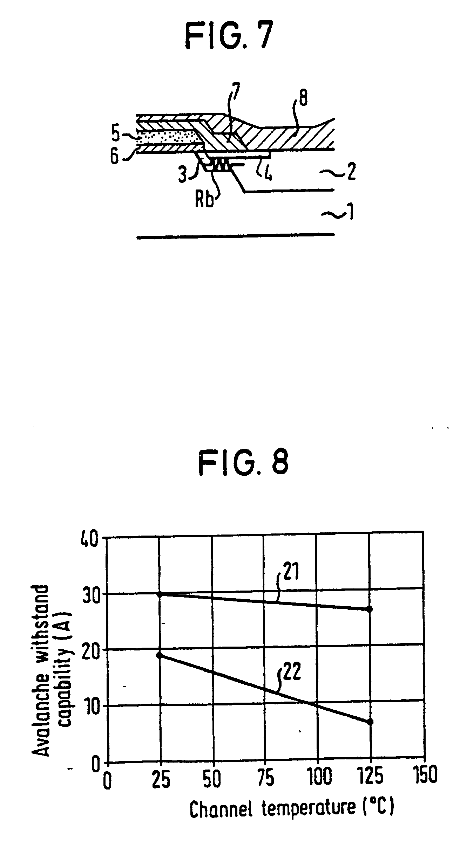

The effect of the invention will be explained with reference to Figs. 6(a) and (b). Fig. 6(a) is a top plan view illustrating the flow of avalanche currents in a conventional MOSFET, and Fig. 6(b) is a top plan view illustrating the flow of avalanche currents in a MOSFET according to the present invention. Referring to Fig. 6(a), the distance between the opposite corners of channel regions 3 of neighbouring cells is longer than the distance between adjacent sides of the channel regions 3 of neighbouring cells. The withstand voltage is low at the corner of each cell because of a large curvature of the channel region 3; therefore, the avalanche currents I1 caused by avalanche breakdown localize to four corners of the channel regions 3 in the region surrounded by the four corners of the channel regions 3 as shown in Fig. 6(a). Because of this, the avalanche withstand capability of a MOSFET is lower at the corners of the quadrangular cells. In contrast, if channel regions 3 are joined on their sides as shown in Fig. 6(b), the corners of the channel regions, at which the avalanche currents may localize, are eliminated. Because avalanche currents I2 are constrained to flow to two facing sides of the channel regions 3, the avalanche withstand capability is improved. As a result, the avalanche current, which flows through a resistance Rb of a channel region 3 beneath the source region 4, shown in Fig. 7, decreases. This decrease in avalanche current prevents a parasitic bipolar transistor, consisting of the n type semiconductor layer 1, the p type channel region 3 and the n+ source regions 4, from conducting, which in turn prevents the MOSFET from breaking down. In this configuration, the curvature of the pn junction between the p type channel region and the n type semiconductor layer is decreased and the withstand voltage is improved.

In a case where cells are arranged along two orthogonal axes, additional comers of the channel regions 3 can be eliminated by also joining a third channel region which is perpendicular to the two parallel channel regions so as to arrange the channel regions in a lattice. In this arrangement, since no corners remain at which the avalanche currents may localize, the avalanche withstand capability and the withstand voltage are further improved.

The provision of a shallow base region of the second conductivity type in a portion of the surface layer of the channel region, the impurity concentration of which is higher than the impurity concentration of the channel region and the diffusion depth of which is shallower than the diffusion depth the channel region, improves the avalanche withstand capability because the conductivity of the channel region 3 increases, the base resistance of the parasitic transistor decreases and, therefore, the operation of the parasitic transistor is nearly prevented. In particular, if the region of the second conductivity type formed under the shallow base region comprises only the channel region, the avalanche withstand capability is improved.

Preferred embodiments of the invention will be described below with reference to the drawings, in which:
- Fig. 1: is a top plan view showing a first embodiment of a MOSFET of the present invention from which an upper structure of the MOSFET is omitted;
- Fig. 2(a): is a sectional view along A-A of Fig. 1;
- Fig. 2(b): a sectional view along B-B of Fig. 1;
- Fig. 3: is a sectional view at the periphery of the MOSFET chip of Fig. 1;
- Fig. 4(a): is a top plan view showing an example of a MOSFET according to the prior art from which an upper structure of the MOSFET is omitted;
- Fig. 4(b): is a sectional view along C-C of Fig. 4(a);
- Fig. 4(c): is a sectional view along D-D of Fig. 4(a);
- Fig. 5: is a graph showing the avalanche withstand capability and ON-resistance versus well depth of the MOSFET according to the prior art;
- Fig. 6(a): is a top plan view illustrating the flow of avalanche currents in a conventional MOSFET from which an upper structure of the MOSFET is omitted;
- Fig. 6(b): is a top plan view illustrating the flow of avalanche currents in a MOSFET according to the present invention;
- Fig. 7: is a sectional view showing a parasitic bipolar transistor which appears near the surface of a MOSFET cell;
- Fig. 8: is a graph comparing the temperature variation of the avalanche withstand capabilities of the MOSFETs of the present invention and the conventional MOSFET;
- Fig. 9: is a top plan view showing a second embodiment of a MOSFET according to the present invention from which an upper structure of the MOSFET is omitted;
- Fig. 10: is a top plan view showing a third embodiment of a MOSFET according to the present invention from which an upper structure of the MOSFET is omitted;
- Fig. 11(a): is a sectional view along E-E of Fig. 9;
- Fig. 11(b): a sectional view along F-F of Fig. 9;
- Fig. 12: is a sectional view along I-I of the third embodiment of Fig. 10;
- Fig. 13: is a sectional view showing a fourth embodiment of a MOSFET according to the present invention; and
- Fig. 14: is a sectional view showing a fifth embodiment of a MOSFET according to the present invention.

Throughout the drawings like reference numerals are used to designate like parts.

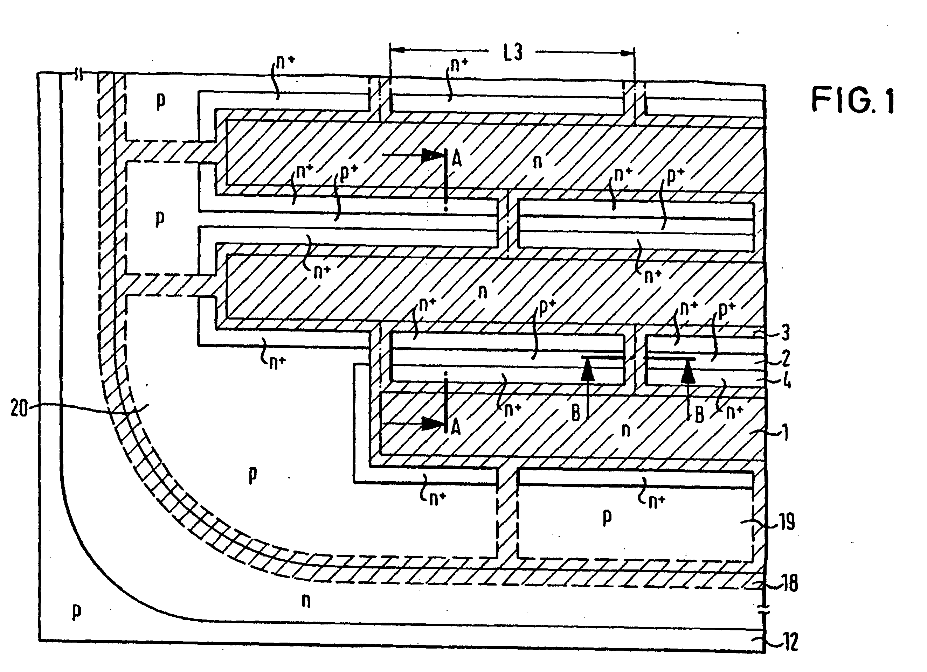

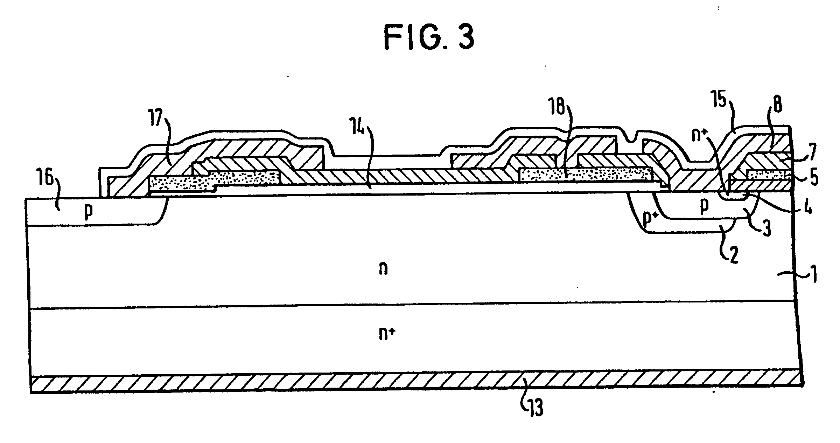

Fig. 1, Fig. 2(a), Fig. 2(b) and Fig. 3 show a first embodiment of a MOSFET of the present invention. As shown in Fig. 1, rectangular p type channel regions 3, which surround respective n⁺ source regions 4 and a p⁺ well region 2, are formed in a surface layer of an n type semiconductor layer 1. The channel region 3 along the short sides of each cell is joined to the channel s regions 3 along parallel short sides of neighbouring cells. The joint boundary is shown in the figure by a single dotted chain line segment. Throughout the embodiments of the present invention, the quadrangular cell is represented by a rectangular cell. The quadrangular cell may be square in some embodiments of MOS type devices. The angle at the actual corners of the channel regions 3 or the source regions 4 are not a right angle but are somewhat curved with a radius of curvature of 1.5 to 2 µm. The channel region 3 is formed in the surface layer of the semiconductor layer 1 with a resistivity of 45 Ωcm and a thickness of 100 µm. The well region 2 is formed from the surface of the channel region 3 and is deeper than the channel region 3. Two source regions 4 are formed in the surface layer of the channel region 3. A poly-crystalline silicon gate electrode 5 is disposed on a gate oxide film 6 on the surface of the channel regions 3 and over the exposed portion of the semiconductor layer 1 between the source regions 4 of two neighbouring cells. A source electrode 8 is disposed in common contact with the source regions 4 and the well region 2 and extends over the gate electrode 5 on an inter-layer insulation film 7. As shown in Fig. 3, a drain electrode 13 is deposited on the back surface of an n⁺ type substrate on which the semiconductor layer 1 is formed.

The first embodiment of a MOSFET illustrated in Figs. 1, 2 and 3 operates as follows. When a positive voltage of more than a predetermined value is applied to the gate electrode 5, an inversion layer is created near the surface of the channel region 3 below the gate electrode 5 and the corresponding portion between the source region 4 and the semiconductor layer 1 becomes conductive. In this situation, a current flows if a voltage is applied between the drain electrode 13 disposed on the back surface of the semiconductor layer 1 and the source electrode 8. Therefore, it is necessary for the exposed portion of the semiconductor layer 1 to have an area great enough to carry the current.

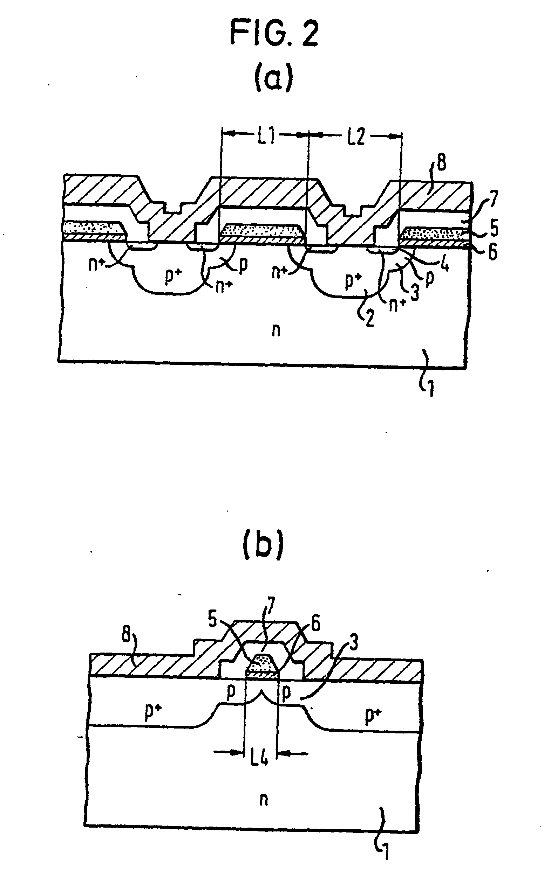

Fig. 2(b) clearly shows a joint between two channel regions 3. In this cross section, no source region is formed in the surface layer of the channel region 3. On the surface of the region in which the channel regions are joined, a narrow poly-crystalline silicone gate electrode 5 is deposited on the gate oxide film 6. The narrow gate electrode 5 links two wide gate electrodes 5 of two neighbouring cells extending in parallel to the plane of the paper. The gate electrode 5 and the source electrode 8 are insulated from one another by the inter-layer insulation film 7.

Referring again to Fig. 1, the channel regions 3 are arranged in a lattice and, due to this, lack many of the corners which exist in devices of the prior art. Because the withstand voltage is lower at the corners where the small curvature of the depletion layer causes a breakdown most often, this elimination of corners avoids a localization of the avalanche currents at the corners and, as a result, improves the avalanche withstand capability. Although the portions surrounded by the cells are wide and, due to the large area, the avalanche currents are large in the surrounded portions, the almost straight pn junctions along the facing sides of neighbouring cells are able to carry the large avalanche currents. Because the semiconductor layer 1 extends widely beneath the gate electrode 5 between the peripheries of the cells illustrated in the section shown in Fig. 2(a), wide current paths are provided when the MOSFET is conductive, therefore, the ON-resistance is low.

In Fig. 1, the left side and the bottom side of the figure are the edges of the MOSFET chip 12. Peripheral cells 19, the outermost side of which is parallel to a respective side of the semiconductor chip 12, and corner cells 20, the outermost side of which is an arc, or approximately an arc, convex toward the corner of the semiconductor chip 12, are arranged outside the portion of the semiconductor chip 12 in which the rectangular cells are arranged. Since the curvature of 10 the outermost pn junctions is made small by this arrangement, the electric field barely localizes and the avalanche withstand capability is improved. An n⁺ source region or regions 4 are formed in a portion of the peripheral cells 19 and in portions of the corner cells 20 facing the inner side of the chip 12.

The avalanche withstand capability is improved for the following reason. Avalanche breakdown usually starts from the outermost pn junction; however, since this portion lacks a source region, the parasitic transistor of the peripheral and corner cells is not switched on even when a large avalanche current flows. As a result, the avalanche withstand capability is improved. Since the peripheral cell 19 and the corner cell 20 can each absorb more avalanche energy by virtue of their greater areas than that absorbed by the rectangular (quadrangular) cell, the avalanche withstand capability is further improved.

The broken line near the peripheral cells 19 indicates a boundary of a poly-crystalline silicon ring 18. The outermost side of the channel region 3 of the corner cell 20 need not be a perfect arc or curve convex towards the corner of the semiconductor chip 12. Even an outermost side approximating an arc by a plurality of short straight lines is effective for avoiding the electric field localization.

Fig. 3 is a sectional view near the edge of the MOSFET chip 12. The poly-crystalline silicon ring 18 for leading out gate leads is disposed on the outermost well region 2 on a thick field oxide film 14, and a p type peripheral region 16 is disposed in the surface layer of the periphery of the chip 12. A peripheral electrode 17 is disposed on the peripheral region 16.

Preferably, the parameters of each part are as follows. The impurity concentration of the n type semiconductor layer 1 is 1x10¹³ to 3x10¹⁶cm⁻³; the thickness of the semiconductor layer 1 is 5 to 150 µm; the boron ion dose amount in the p⁺ well region 2 is 5x10¹⁴ to 2x10¹⁵ cm⁻²; the diffusion depth of the well region 2 is 5 to 10 µm; the boron ion dose amount in the p type channel region 3 is 3x10¹³ to 5x10¹⁴ cm⁻²; the diffusion depth of the channel region 3 is 2 to 4 µm; the arsenic ion dose amount in the n⁺ source region 4 is 4x10¹⁵ to 5x10¹⁵ cm⁻²; the diffusion depth of then source region 4 is 0.2 to 0.3 µm; the thickness of the gate electrode (poly-crystalline silicon) 5 is 500 to 1000nm; the thickness of the gate oxide film 6 is 25 to 120 nm; the thickness of the inter-layer insulation film (BPSG) 7 is 0.6 to 1.1 µm; the thickness of the source electrode (Al-Si) 8 is 3 to 5 µm; the thickness of the field oxidation film 14 is 500 to 1100 nm; and the thickness of the passivation film (SiN) is 800 nm. The width L1 of the wide gate electrode 5 in Fig. 2(a) is 6 to 40 µm; the spacing L2 between the gate electrodes 5 is 6 to 20 µm; the length L3 of the source region 4 is 12 to 200 µm; and the width L4 of the narrow gate electrode 5 is 4 to 6 µm.

The MOSFET of Figs. 1, 2 and 3 can be manufactured by the following steps. An epitaxial wafer is prepared by forming an n type semiconductor layer 1 on an n⁺ type substrate. p⁺ well regions 2 are formed by selectively doping acceptor type impurities from the surface of the semiconductor layer 1. A poly-crystalline silicon film is deposited by CVD under reduced pressure on a gate oxide film 6 formed by thermal oxidation. The poly-crystalline silicon film is patterned to result in the gate electrodes 5. p type channel regions 3 and n⁺ source regions 4 are self-aligned by ion-implantation using the gate electrodes 5 as masks for the self-alignment and by subsequent thermal diffusion. An inter-layer insulation film 7 of BPSG is deposited by the CVD method on the gate electrodes 5. Windows are opened on the well region 2 and the source regions 4, and the source electrode 8 of Al-Si alloy is disposed. A nitride passivation film 15 is laminated on the source electrode 8. Finally the drain electrode 13 is deposited on the back surface of the substrate.

In Fig. 1, hatching indicates the portions on which the poly-crystalline silicon for the gate electrodes 5 and the poly-crystalline silicon ring 18 are deposited. Below the narrow gate electrode 5 which connects the wider gate electrodes 5 on the semiconductor layer 1, the channel regions 3 are joined by lateral impurity diffusion. Many narrow gate electrodes 5, which are narrow enough to allow joining of the channel regions by lateral impurity diffusion, are effective to lower the resistance to the currents flowing through the gate electrodes and to uniformly bias the gate electrodes. The first embodiment of the MOSFET can be manufactured by changing the mask patterns without adding any extra steps to the manufacturing process of the MOSFET of the prior art.

Fig. 8 is a graph comparing the temperature dependence of the avalanche withstand capability of the MOSFET according to the first embodiment of the present invention with that of the conventional MOSFET of Fig. 4. The withstand capability of the first embodiment of the present invention shown by a line 21 is 1.6 times at 25°C and 4.7 times at 125°C as large as the withstand capability of the conventional MOSFET shown by line 22.

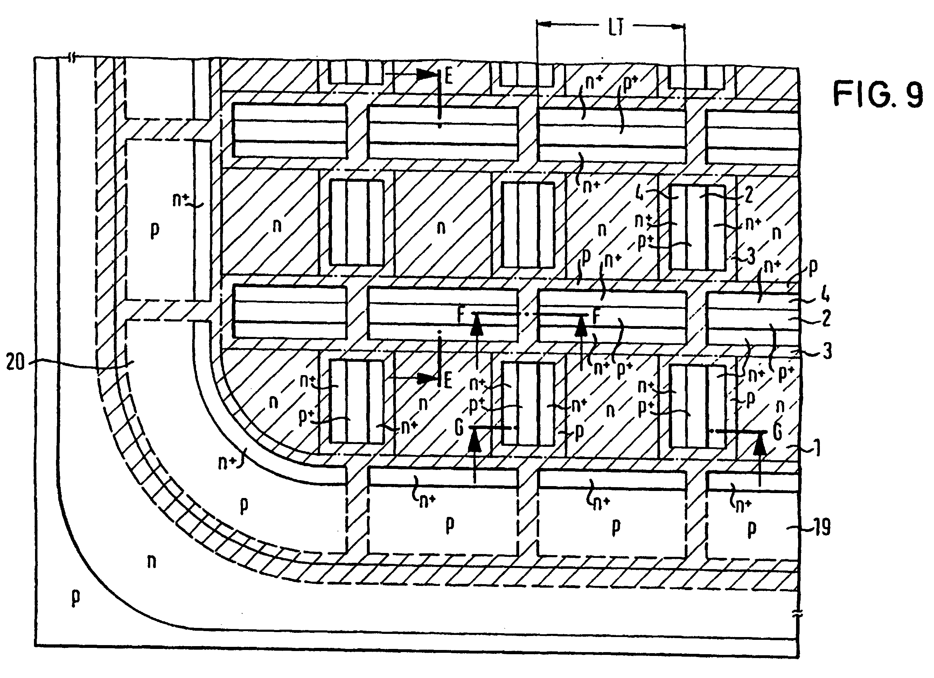

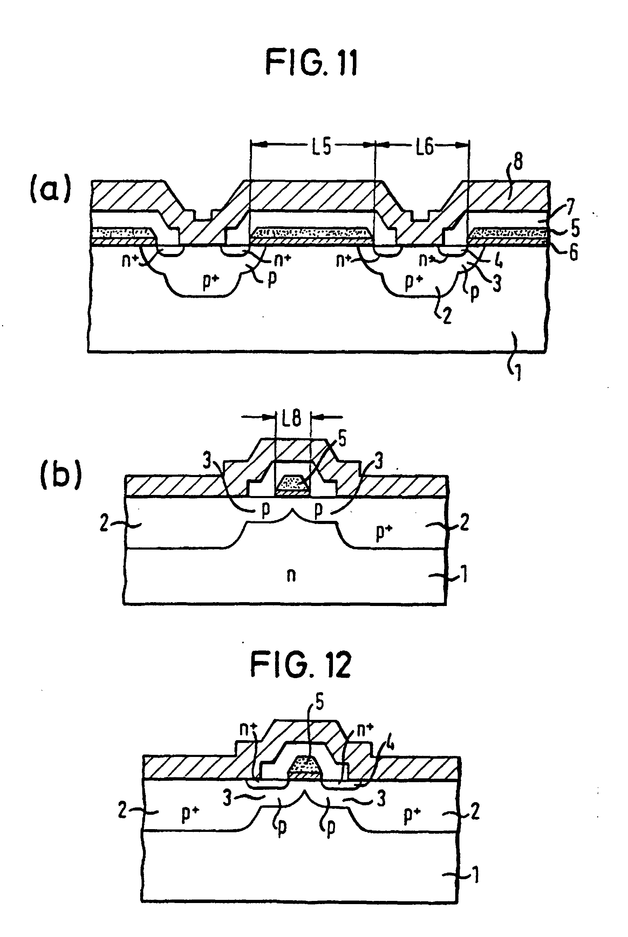

Figs. 9, 11(a) and 11(b) show a second embodiment of a MOSFET according to the present invention. The embodiment shown in Fig. 9 is a modification of the first embodiment. In Fig. 9, the parallel short sides of the channel regions 3 of two neighbouring rectangular cells are joined together and are also joined to a channel region 3 along the short side of another cell, the side of the third cell being perpendicular to the two other short sides. In Fig. 9, two n⁺ source regions 4 are formed in each of the joined p type channel regions 3, and a respective p⁺ well region 2 is formed between the two source regions 4. Square exposed regions of the n type semiconductor layer 1 are surrounded by the orthogonally arranged channel regions 3. The cross sectional view shown in Fig 11(a) is almost the same as that shown in Fig. 2(a). That is, the channel regions 3, each surrounding a deep well region 2, are formed in the surface layer of the semiconductor layer 1. Two source regions 4 are formed in the surface layer of each channel region 3. The gate electrode 5 is disposed on the gate oxide film 6 on the surface of the channel regions 3 and on the semiconductor layer 1 sandwiched between the two facing source regions 4 of two neighbouring cells. The source electrode 8 is disposed so as to contact both the source regions 4 and the well region 2 in each cell. It should be easily seen that a sectional view along the line segment G-G in Fig. 9 would be almost the same as that shown in Fig. 11(a). As shown in Fig. 9(b), in the cross section along the line segment F-F of Fig. 9, two channel regions 3 are joined similarly to those shown in Fig, 11(a). That is, the channel regions 3 are joined in the surface layer of the semiconductor layer 1. The narrow gate electrode 5 is disposed on the gate oxide film 6 above the joined channel regions 3. Thus, by joining the channel regions 3, a reduction of the withstand voltage at the cell corners and a reduction of the withstand capability are prevented. The width L8 of the narrow gate electrode 5 is 2 to 6 µm. In the section shown in Fig. 11(a), two cells are spaced widely enough and the semiconductor layer 1 is exposed below the gate electrode 5 widely enough so that the ON-resistance of the MOSFET is low when the MOSFET is conducting. The width L5 of the (wide) gate electrode 5 is 16 to 190 µm, the spacing L6 between the (wide) gate electrodes 5 is 6 to 20 µm. The length L7 of the source region 4 is 12 to 200 µm in this cross section.

In this second embodiment as in the first embodiment, the peripheral cells 19 are formed in the peripheral portion of the semiconductor chip, inside which the rectangular cells are formed, as shown in Fig. 9. The outermost side of channel regions 3 of the peripheral cells 19 is parallel to the respective side of the semiconductor chip, and only one source region 4 is formed along the central side of each peripheral cell 19. Each peripheral cell 19 has a greater area than each rectangular cell. The outermost side of the channel region 3 of the corner cell 20 lies along an arc, or an approximated arc, which is convex toward the corner of the semiconductor chip, and the corner cell 20 has a greater area than the peripheral cells 19. By this configuration, the second embodiment also contributes to the improvement of the avalanche withstand capability.

The second embodiment shown in Fig. 9 is preferable to the first embodiment shown in Fig. 1 for lowering the ON-resistance, since the total area of the channel regions 3 and that of the source regions 4 are greater in the second embodiment.

The second embodiment of the present invention also can be manufactured by changing only the mask patterns without adding steps to the processing method of the prior art.

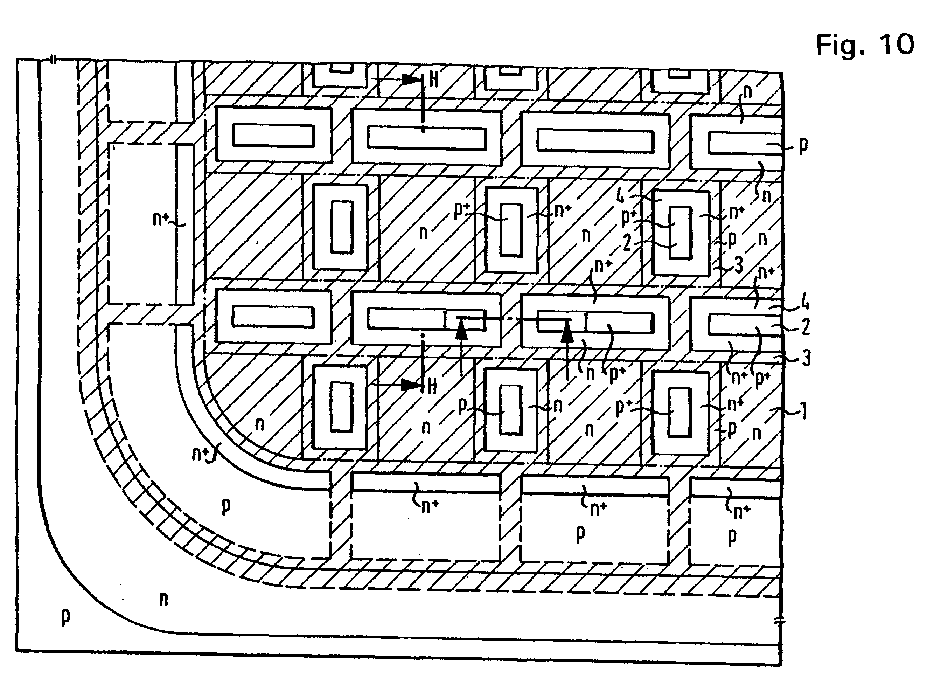

Fig. 10 shows a third embodiment of a MOSFET according to the present invention. Fig. 10 is a top plan view from which an upper structure of the MOSFET is omitted. The third embodiment is a modification of the second embodiment of Fig. 9. The cells are arranged orthogonally to form a lattice similar to that formed in the second embodiment. However, the third embodiment differs from the second embodiment in that an n⁺ source region 4 is formed as a rectangular ring in each rectangular cell. Therefore, the cross section along H-H in Fig. 10 is similar to that of Fig. 11(a). However, the cross section along I-I of Fig. 10 shown in Fig. 12 is different from that shown in Fig. 11(b). In Fig. 12, unlike Fig. 11(b), the n⁺ source regions 4 also exist in the joint portion of the p type channel regions 3. The third embodiment further reduces the ON-resistance since the third embodiment enlarges the area of the source regions 4. It goes without saying that in case of quadrangular cells other than rectangular cells the source regions will have a corresponding quadrangular ring shape.

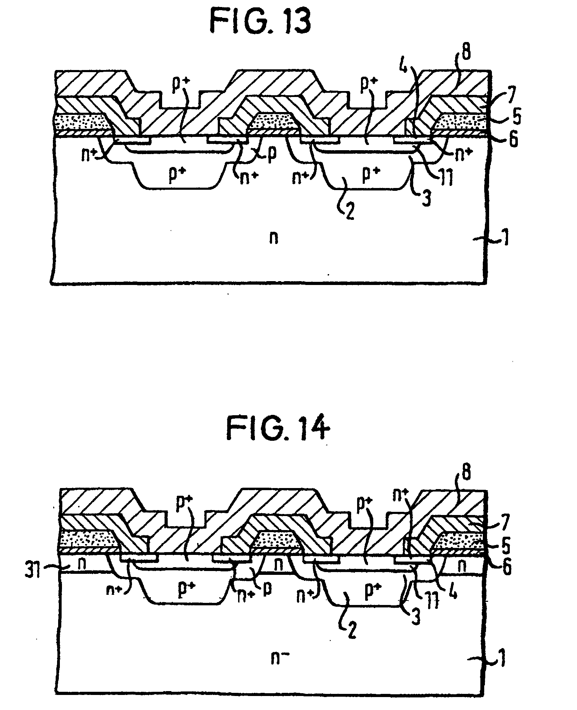

Fig. 13 is a sectional view showing a fourth embodiment of a MOSFET according to the present invention. In the fourth embodiment, a shallow p⁺ base region 11 with shallow diffusion depth and with higher impurity concentration than that of the p type channel region 3 is formed in a part of the surface layer of the p type channel region 3. The shallow base region 11 is formed, for example, by implanting boron ions at the ion dose amount of 1x10¹⁵ to 3x10¹⁵ cm⁻², and by heat treatment to the diffusion depth of 0.5 to 1 µm. Since the channel resistance is lowered by the shallow base region 11, the operation of the parasitic transistor is more reliably suppressed and the avalanche withstand capability is improved.

As will be appreciated, the sectional view of Figs. 13 corresponds to those of Figs. 2(a) and 11(a). The fourth embodiment may be combined with any of the first to third embodiments. In other words, for each of the first to third embodiments any of the following three combinations can be adopted: (1) the p type channel region 3 and the p⁺ well region 2; and (2) the p type channel region 3, the p⁺ well region 2, and the shallow p+ base region 11.

Fig. 14 is a sectional view showing a fifth embodiment of a MOSFET according to the present invention. The fifth embodiment is a modification of any one of the first through fourth embodiments, and Fig. 14 corresponds to Fig. 13. The fifth embodiment differs from the first through fourth embodiments in that a semiconductor region 31 of the same conductivity type as the semiconductor layer 1 is formed in a surface region of the latter. A feature of the fifth embodiment is that the resistivity of the semiconductor region 31 is lower than that of the semiconductor layer 1. In Fig. 14, this is exemplified by n- type for the semiconductor layer 1 and n type for the semiconductor region 31. While, generally, the resistivity of the semiconductor region 31 should be higher than that of the source region(s) 4 this is not essential . The phosphor ion dose amount for the n type semiconductor region 31 is preferably 5 x 10¹¹ to 5 x 10¹² cm⁻² and the diffusion depth of the semiconductor region 31 is preferably 2 to 4 µm. The semiconductor region 31 enables higher doping concentration than the prior art does and results in a lower on-resistance. In addition, a smaller area for one element of the device, which is possible thanks to the low resistivity of the semiconductor region 31, decreases the gate-drain capacitance, which in turn makes faster switching possible. This sixth embodiment can be combined with any of the first to fifth embodiments.

Although the present invention has been explained by specific embodiments of MOSFET devices, the present invention is applicable to other MOS devices such as MOS controlled bipolar transistors, MCTs (MOS controlled thyristors), etc. Furthermore, although the invention has been described with reference to certain conductivity types in the embodiments, it will be appreciated that these conductivity types may be exchanged for each other.

## Claims

1. A MOS type semiconductor device, comprising:
a semiconductor layer (1) of a first conductivity type, and
a plurality of MOS type rectangular cells, each having four major sides including short and long major sides and including
- a channel region (3) of a second conductivity type formed in a surface layer of the semiconductor layer (1), and
- one or more source regions (4) of the first conductivity type formed in the surface layer of the channel region (3), at least two sides of said one or more source regions (4) lying in parallel to at least two sides of the channel region,
wherein said plurality of rectangular cells are formed in a central portion of a semiconductor chip and MOS type peripheral cells (19) are formed in a peripheral portion of the semiconductor chip, the peripheral cell Including a channel region (3) of the second conductivity type, a source region (4) of the first conductivity type and a well region (2) of the second conductivity type with a higher impurity concentration and a greater depth than those of the channel region of a peripheral cell, and at least a portion of the outermost side of the channel region of the peripheral cell lies In parallel to a respective side of the semiconductor chip,
**characterized in that**
the area of a peripheral cell (19) is greater than that of a rectangular cell,
the plurality of MOS type rectangular cells, like the peripheral cells, each have a well region (2) of the second conductivity type with a higher impurity concentration and a greater depth than those of the channel region of a rectangular cell, and
the channel regions (3) of first and second neighbouring cells, which have the short major sides facing each other in parallel, are joined along the facing short major sides thereof.

2. The device as claimed in claim 1, wherein MOS type comer cells (20) are formed in the peripheral portions corresponding to the comers of the semiconductor chip, each comer cell including a channel region (3) of the second conductivity type and a source region (4) of the first conductivity type, and wherein the outermost side of the channel region of each corner cell forms or approximates an arc convex toward the respective comer of the semiconductor chip, and the area of a corner cell is greater than that of a peripheral cell.

3. The device as claimed in claim 1 or 2, wherein a base region (11) of the second conductivity type is formed in a portion of the surface layer of the channel region (3), the impurity concentration of the base region being higher and its diffusion depth being shallower than those of the channel region.

4. The device as claimed in any one of claims 1 through 3, wherein a gate electrode (5) is formed on each joined portion of the channel regions (3).

5. The device as claimed in any one of claims 1 through 4, wherein each joined portion of the channel regions (3) comprises a lateral impurity diffusion layer.

6. The device as claimed in any one of claims 1 through 5, wherein a further region (31) of the first conductivity type is formed in the. surface area of the substrate extending between the channel regions (3) of neighbouring cells along those major sides of said cells which are not joined, the further region having an impurity concentration higher than that of the substrate.

## Patentansprüche

1. MOS-Halbleitervorrichtung, umfassend:
eine Halbleiterschicht (1) eines ersten Leitfähigkeitstyps, und
eine Mehrzahl von rechteckigen MOS-Zellen, von denen jede vier Hauptseiten mit kurzen und langen Hauptseiten umfaßt und enthält
- einen Kanalbereich (3) eines zweiten Leitfähigkeitstyps, der in einer Oberflächenschicht der Halbleiterschicht (1) gebildet ist, und
- einen oder mehrere in der Oberflächenschicht des Kanalbereichs (3) gebildete Source-Bereiche (4) des ersten Leitfähigkeitstyps, wobei zumindest zwei Seiten des einen oder der mehreren Source-Bereiche (4) parallel zu mindestens zwei Seiten des Kanalbereichs liegen,
wobei die Mehrzahl von rechteckigen Zellen in einem mittleren Abschnitt eines Halbleiterchips gebildet sind und periphere MOS-Zellen (19) in einem peripheren Abschnitt des Halbleiterchips gebildet sind, die periphere Zelle einen Kanalbereich (3) des zweiten Leitfähigkeitstyps, einen Source-Bereich (4) des ersten Leitfähigkeitstyps und ein Wannenbereich (2) des zweiten Leitfähigkeitstyps mit einer höheren Dotierstoffkonzentration und einer größeren Tiefe als diejenigen in dem Kanalbereich einer peripheren Zelle umfaßt, und wenigsten ein Abschnitt der äußersten Seite des Kanalbereichs der periphere Zelle parallel zu einer entsprechenden Seite des Halbleiterchips liegt,
**dadurch gekennzeichnet, daß**
die Fläche einer peripheren Zelle (19) größer als die einer rechteckigen Zelle ist,
die Mehrzahl der rechteckigen MOS-Zellen, wie die peripheren Zellen, je einen Wannenbereich (2) des zweiten Leitfähigkeitstyps mit einer höheren Dotierstoffkonzentration und einer größeren Tiefe als diejenigen des Kanalbereichs einer rechteckigen Zelle aufweisen, und
die Kanalbereiche (3) erster und zweiter benachbarter Zellen, deren einander zugewandte Hauptseiten parallel sind, miteinander längs der einander zugewandten kurzen Hauptseiten verbunden sind.

2. Vorrichtung nach Anspruch 1, bei der MOS-Eckzellen (20) in den peripheren Abschnitten gebildet sind, die den Ecken des Halbleiterchips entsprechen, wobei jede Eckzelle einen Kanalbereich (3) des zweiten Leitfähigkeitstyps und einen Source-Bereich (4) des ersten Leitfähigkeitstyps aufweist, und bei der die äußerste Seite des Kanalbereichs jeder Eckzelle einen Bogen bildet oder approximiert, der konvex zur jeweiligen Ecke des Halbleiterchips ist, und bei der die Fläche einer Eckzelle größer als diejenige einer peripheren Zelle ist.

3. Vorrichtung nach Anspruch 1 oder 2, bei der ein Basisbereich (11) des zweiten Leitfähigkeitstyps in einem Abschnitt der Oberflächenschicht des Kanalbereichs (3) ausgebildet ist, wobei die Dotierstoffkonzentration des Basisbereichs höher und seine Diffusionstiefe flacher als jene des Kanalbereichs sind.

4. Vorrichtung nach einem der Ansprüche 1 bis 3, bei der eine Gateelektrode (5) auf jeden verbundenen Abschnitt der Kanalbereiche (3) ausgebildet ist.

5. Vorrichtung nach einem der Ansprüche 1 bis 4, bei der jeder verbundene Abschnitt der Kanalbereiche (3) eine seitliche Dotierstoffdiffusionsschicht umfaßt.

6. Vorrichtung nach einem der Ansprüche 1 bis 5, bei der ein weiterer Bereich (31) des ersten Leitfähigkeitstyps im Oberflächenbereich des Substrats ausgebildet ist, der sich zwischen den Kanalbereichen (3) von benachbarten Zellen entlang derjenigen Hauptseiten der Zellen, die nicht verbunden sind, erstreckt, wobei der weitere Bereich eine höhere Dotierstoffkonzentration als die des Substrats aufweist.

## Revendications

1. Dispositif à semi-conducteur de type MOS, comportant :
une couche (1) de semi-conducteur d'un premier type de conductivité, et
une pluralité de cellules rectangulaires de type MOS, chacune ayant quatre côtés principaux incluant des côtés principaux courts et longs et comportant
- une région (3) de canal d'un second type de conductivité formée dans une couche de surface de la couche (1) de semi-conducteur, et
- une ou plusieurs régions (4) de source du premier type de conductivité formée dans la couche de surface de la région (3) de canal, au moins deux côtés de la ou des régions (4) de source étant parallèles à au moins deux côtés de la région (3) de canal,
dans lequel la pluralité de cellules rectangulaires sont formées dans une partie centrale d'une puce à semi-conducteur et des cellules (19) périphériques de type MOS sont formées dans une partie périphérique de la puce à semi-conducteur, chaque cellule périphérique comportant une région (3) de canal du second type de conductivité, une région (4) de source du premier type de conductivité et une région (2) de puits du second type de conductivité de plus grande concentration en impuretés et de plus grande profondeur que celles de la région de canal d'une cellule périphérique, et au moins une partie du côté le plus à l'extérieur de la région de canal de la cellule périphérique est parallèle à un côté respectif de la puce à semi-conducteur,
**caractérisé en ce que**
la surface de la cellule (19) périphérique est plus grande que celle d'une cellule rectangulaire,
la pluralité des cellules rectangulaires de type MOS, comme les cellules phériphériques, ont chacune une région (2) de puits du second type de conductivité ayant une concentration en impuretés plus grande et une
la surface de la cellule (19) périphérique est plus grande que celle d'une cellule rectangulaire,
la pluralité des cellules rectangulaires de type MOS, comme les cellules phériphériques, ont chacune une région (2) de puits du second type de conductivité ayant une concentration en impuretés plus grande et une profondeur plus grande que celle de la région de canal d'une cellule rectangulaire, et
les régions (3) de canal des première et deuxième cellules voisines qui ont les côtés principaux courts se faisant face parallèlement sont réunies le long de leur côté principal court se faisant face.

2. Dispositif suivant la revendication 1, dans lequel des cellules (20) de coin de type MOS sont formées dans les parties périphériques correspondant aux coins de la puce à semi-conducteur, chaque cellule de coin comportant une région (3) de canal du second type de conductivité et une région (4) de source du premier type de conductivité, et dans lequel le côté le plus à l'extérieur de la région de canal de chaque cellule de coin forme un arc ou à peu prés un arc dont la convexité est tournée vers le coin respectif de la puce à semi-conducteur, la surface d'une cellule de coin étant supérieure à celle d'une cellule périphérique.

3. Dispositif suivant la revendications 1 ou 2, dans lequel une région (11) de base du second type de conductivité est formée dans une partie de la couche de surface de la région (3) de canal, la concentration en impuretés de la région de base étant plus grande et sa profondeur de diffusion étant plus petite que celles de la région de canal.

4. Dispositif suivant l'une quelconque des revendications 1 à 3, dans lequel une électrode (5) de grille est formée sur chaque partie réunie des régions (3) de canal.

5. Dispositif suivant l'une quelconque des revendications 1 à 4, dans lequel chaque partie réunie des régions (3) de canal comporte une couche de diffusion d'impuretés latérale.

6. Dispositif suivant l'une quelconque des revendications 1 à 5, dans lequel une région (31) supplémentaire de premier type de conductivité est formée dans la surface du substrat s'étendant entre les régions (3) de canal de cellules voisines le long des côtés principaux des cellules qui ne sont pas réunis, la région supplémentaire ayant une concentration en impuretés supérieure à celle du substrat.
